# EUROPEAN PATENT SPECIFICATION

(11) **EP 0 891 835 B1**
(45) Date of publication and mention of the grant of the patent: **10.09.2003**
(21) Application number: 98305540.1
(22) Date of filing: 10.07.1998
(51) Int. Cl.: B23K 1/005

(54) **Method for attaching electronic components to substrates**
Verfahren zum Verbinden von elektronischen Bauelementen auf einem Substrat
Méthode pour connecter des composants électroniques sur un substrat

(30) Priority: 14.07.1997 US 891912
(43) Date of publication of application: 20.01.1999
(73) Proprietor: Ford Motor Company, Dearborn, MI 48126 (US)
(72) Inventor: Meyer, Bernard A., Taylor, Michigan 48180 (US); Kneisel, Lawrence L., Novi, Michigan 48375 (US); Baker, Jay D., W. Bloomfield, Michigan 48323 (US); Achari, Achyuta, Canton, Michigan 48188 (US); Jairazbhoy, Vivek Amir, Farmington Hills, Michigan 48331 (US)
(74) Representative: Messulam, Alec Moses

(56) References cited:
- US-A- 5 023 426
- US-A- 5 175 410
- US-A- 5 506 385

## Description

The present invention relates generally to attaching an electronic component to a substrate. More particularly, the present invention relates to attaching an electronic component to a substrate by selective heating of the mounting pad/termination interface area immediately before or after the deposition of a bonding compound thereat.

Electronic components are typically connected to the mounting pads of a printed circuit board (PCB) by a process of (1) depositing solder paste onto the mounting pads, (2) placing the components on the PCB such that the component's terminations register upon their respective mounting pads, thereby creating a PCB assembly, (3) placing the PCB assembly in a reflow oven which brings all the members of the assembly up to a temperature sufficiently high to melt (i.e., reflow) the solder paste, and (4) cooling the PCB assembly so that the molten solder paste depositions solidify so as to form solder joints which electrically and mechanically connect each component termination to its respective mounting pad.

Such a process works well for conventional substrates, which are generally planar in shape and constructed of materials such as glass-filled epoxy, polyethylene terephthalate, and so forth which can withstand the high temperature profile found within the aforementioned reflow ovens. However, when the substrate is formed in a shape which is curviplanar rather than planar, or is constructed of a material which cannot withstand reflow oven temperatures without melting or experiencing some degree of structural distortion or thermal degradation, the aforementioned process cannot be effectively used.

It is desirable, therefore, to provide a method for processing PCB assemblies-that is, to provide the joints which electrically and mechanically connect the component terminations to their respective mounting pads-which does not rely upon the use of a reflow oven, nor even upon raising the substrate to elevated processing temperatures.

One prior art method for accomplishing this is disclosed in U.S. Pat. No. 5,364,011 to Baker et al., which is assigned to the assignee of the present invention. This method involves the use of a molten solder dispensing device to deposit globlets of molten solder directly onto the component terminations and/or substrate mounting pads. Once the molten solder is deposited, it cools and forms a solid solder joint which mechanically and electrically connects together the terminations and mounting pads. Since the solder is already molten when dispensed, no subsequent reflow process is needed. In this process, Baker et al. teach that the substrate may remain at ambient temperature or may be preheated to around 40°C; thus, the substrate on the whole remains at a temperature well below the melting or thermal degradation points of the substrate material. Also, although each deposition of molten solder is very hot, each deposition causes only localised thermal excursions in the plastic substrate material immediately adjacent each deposition. Furthermore, these localised excursions in the substrate are relatively short-lived because much of the heat from the deposited globlets gets absorbed by the metal terminations and mounting pads and is very quickly dissipated into the component, circuit traces, and surrounding atmosphere, rather than being transferred into the substrate.

However, one drawback of this molten solder dispenser is that sometimes it is difficult to produce repeatably consistent and/or otherwise robust solder joints because of the large thermal gradient which exists between the relatively hot molten solder globlets and the relatively cool mounting pads/terminations. This steep thermal gradient causes the heat from the molten solder globlet to be wicked away too quickly by the mounting pad, termination, and substrate, thus preventing the solder from having enough time to wet and flow across the mounting pad. As a result, the solder joint does not extend underneath the component terminations as much as might be desired. It is also a drawback that this dispenser is limited to dispensing only molten solder and not other bonding compounds. It would be desirable to provide an apparatus and a method for using the same which is capable of reducing the thermal gradient between the mounting pads/terminations and the molten solder, yet without having to raise the temperature of the whole substrate. It would further be desirable that this type of dispenser be capable of dispensing other forms of bonding compound.

The present invention overcomes the disadvantages of the prior art by providing an improved method for attaching an electronic component to a substrate having a curviplanar surface on which the mounting pads are mounted, and/or when the substrate is constructed of a material that is more heat sensitive than conventional substrate materials.

The present invention provides a method of attaching an electronic component having at least one termination to a substrate having at least one mounting pad, the attachment being between the termination and a selected mounting pad, the method comprising; placing the component on the substrate so that the termination is over the selected mounting pad, dispensing a predetermined amount of bonding material over the selected mounting pad either before or after the placement of the component on the substrate, selectively heating the selected mounting pad to a predetermined temperature by focussing heat to the selected mounting pad, either before or after the dispensing of the bonding material, and controlling the sequence, timing and operation of the steps of the method so that the bonding material is heated to form the said attachment without recourse to a reflow oven.

The bonding compound may be a molten solder, a molten brazing compound, an electrically conductive adhesive, as well as other similar compounds. The selective heating may be effected by such means as infrared (IR) lamps, ultraviolet (UV) lamps, and/or lasers, with diode lasers operating within a particular frequency range being the preferred method.

It is an advantage that the present invention may be used to form mechanical and electrical connections between component terminations and their respective mounting pads without having to elevate the overall substrate temperature to those temperatures found in conventional reflow ovens. This allows for the use of substrate materials having lower melting, degradation, and heat distortion points than is the case for conventional substrate materials. (As used herein, a "heat distortion point" is the temperature at which a given plastic part made of a given type of plastic material may experience significant, unacceptable structural distortion due to elevated temperature.)

It is another advantage that the present invention may be used even when the substrate is planar in shape or is constructed of conventional substrate materials.

It is a further advantage that the present invention may form the aforementioned mechanical and electrical connections using a variety of different bonding compounds.

The invention will now be described, by way of example, with reference to the accompanying drawings, in which:
FIG. 1 is a schematic diagram of process steps according to three methods of the present invention;
FIG. 2 is a schematic diagram of subsystem elements comprising an apparatus according to the present invention; and
FIG. 3 is a side view of one embodiment of an apparatus according to the present invention.

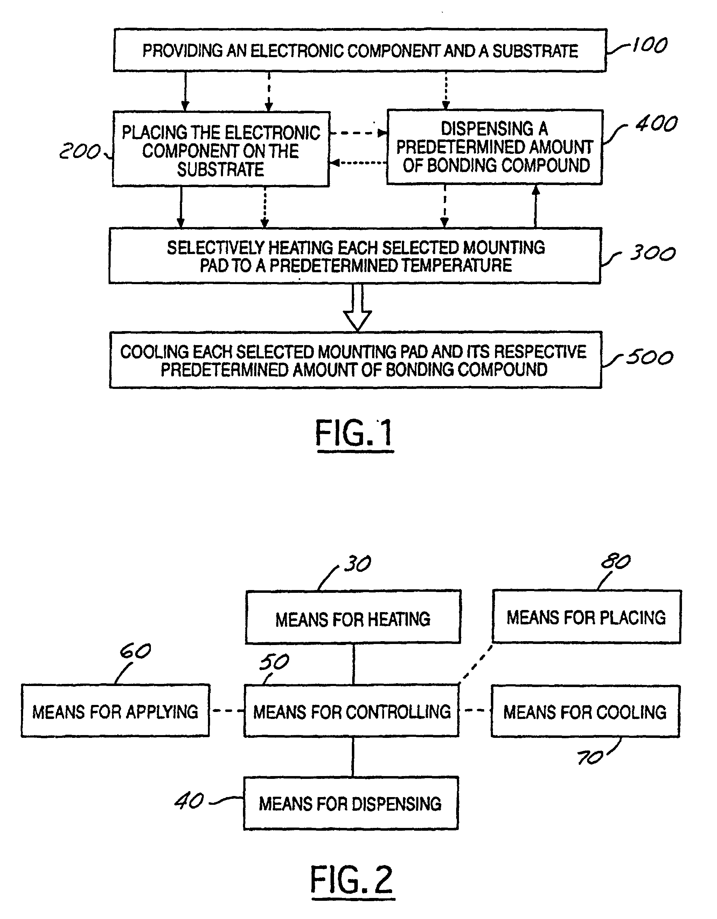

Referring now to the drawings, FIG. 1 shows a schematic diagram of three related methods in accordance with the present invention for attaching an electronic component 10 having at least one termination 12 to a substrate 14 having a respective mounting pad 16 for each termination 12. The first of these three methods comprises a first step 100 of providing the electronic component 10 and the substrate 14, a second step 200 of placing the component 10 on the substrate 14 such that each termination 12 rests atop its respective mounting pad 16, a third step 300 of selectively preheating at least one selected mounting pad 16 to a predetermined temperature, and a fourth step 400 of dispensing a predetermined amount of bonding compound 18 onto each selected mounting pad 16 immediately after the preheating step 300. The process flow of this first method is represented in FIG. 1 by the solid arrows. An additional step 500 may comprise cooling each selected mounting pad 16 and its respective predetermined amount of bonding compound 18, so as to form a solid joint 20 of bonding compound thereat which electrically and mechanically connects each selected mounting pad 16 to its respective termination 12. This cooling step 500 may be accomplished, for example, by directing cool air or nitrogen gas at the mounting pads/bonding compound, or by simply allowing the mounting pad/bonding compound to cool without the introduction of any additional cooling means. A further additional step (not shown) comprises applying a predetermined amount of surface preparation compound 22, such as a flux or cleaning compound, to each termination 12 and/or each mounting pad 16 at some point between the providing step 100 and the dispensing step 400.

By selectively heating only the mounting pads 16, it is possible to avoid heating the entire substrate 14 to dangerously high temperatures that would otherwise melt, degrade, or structurally distort the substrate. This is of particular concern when the substrate is constructed of a low melting point plastic, such as polystyrene or polypropylene. In the present invention, the substrate is heated by the selective preheating step only immediately adjacent each selectively preheated mounting pad 16. Even if several mounting pads are preheated at once, such as when simultaneously heating all the mounting pads along one side of a component, it is possible to focus the application of heat on only this small, localised area so that only that portion of the substrate between and immediately adjacent to these pads is affected. In addition, by focusing the application of heat to only a selected number of mounting pads at one time it is possible to elevate these selected mounting pads to a higher temperature than would be allowable were the entire substrate being heated. All of these factors contribute toward allowing the mounting pad/termination interface to be sufficiently heated and a bonding compound joint 20 to be formed thereat without having to subject the entire substrate to such heat.

Various means may be employed for effecting the selective preheating step 300. While it is possible to use any number of contact means such as conventional hot bar heaters, it is preferred that some form of non-contact means be utilised. (As used herein, "non-contact" means that the means for heating does not physically come into contact with the selected mounting pads.) Such means may include an IR heat source, a UV heat source, a stream of heated inert gas, and/or a laser, with some form of masking means optionally being used therewith. The masking means would cover the general area at which a joint is being formed, but would include one or more apertures arranged such that only one or more mounting pads is/are exposed to the IR or UV source. The selection of which non-contact heat source is to be used may be determined by the particular type of bonding compound to be dispensed.

The preferred non-contact means for effecting the selective preheating step is a laser, in large part because of its ability to provide a very focused, high intensity beam of energy without the need for any masking means. While various lasers may be used, such as CO₂, argon, or Nd:YAG, the preferred approach uses a diode laser. This type of laser is capable of high energy output levels and operates in a desirable frequency range of 800-980 nm (whereas CO₂ systems operate at 10.6 nm, argon at 200-530 nm, Nd:YAG at 10.6 nm or 200-530 nm, and helium-neon at 633 nm). This frequency range is desirable because at a subset of this range-namely, at 900-950 nm-metals readily absorb the laser energy, but plastics tend not to. This property has clear advantages in that a plastic substrate would tend not to absorb any "stray" (e.g., misfocused) energy from a laser used in this frequency range, while any metallic elements (i.e., the mounting pad and the termination) would.

The bonding compound 18 that is dispensed in the dispensing step 400 may be a molten solder, a molten brazing compound, or an electrically conductive adhesive.

The solder or brazing compound would already be molten when dispensed, but the adhesive may be at a temperature either higher or lower than its curing temperature when dispensed. For the latter case, the one or more selected mounting pads would be preheated to a predetermined temperature such that when the adhesive is dispensed immediately following the preheat step, there would be sufficient heat present in the mounting pad (and/or available to the mounting pad from the adjacent termination and substrate) to elevate the adhesive above its curing temperature for a time long enough to cure the adhesive and form a satisfactory joint 20. For the former case, the selected mounting pads would be heated such that sufficient heat is provided so that the adhesive remains above its cure temperature long enough after dispensing to cure and effect a satisfactory joint. (For this former case, prior to dispensing it may be necessary to seal the hot adhesive away from the atmosphere, or to enshroud any free surfaces of the hot adhesive in an inert gas, in order to avoid premature curing thereof.) Similarly, in the case of a molten solder or molten brazing compound, the mounting pads would be heated to a predetermined temperature such that sufficient heat would be provided thereat to allow the solder or brazing compound to wet and flow across the mounting pad sufficiently so that a satisfactory joint is formed. In addition to whatever bonding compound is selected, it may be desirable to include therein some form of surface preparation compound, such as flux or a cleaning compound. Alternatively, rather than included this in the bonding compound, it is possible to include a separate step 600 of applying a surface preparation compound to the terminations or mounting pads at some point between the providing step 100 and the dispensing step 400, as mentioned above.

It should be appreciated that the predetermined temperature to which the mounting pads are preheated, and the predetermined amount of bonding compound which is sufficient to satisfactorily join each mounting pad and its respective termination together electrically and mechanically, are to be determined on a case-by-case basis depending on such factors as the type of bonding compound to be used, the materials and dimensions of the mounting pads and terminations, the material characteristics of the substrate, and any other machinery and process constraints given. For example, it has been found that using eutectic tin-lead solder heated to approximately 300°C as the bonding compound, a satisfactory joint can be produced for a variety of common SMD/copper mounting pad configurations if the pad is pre-heated to around 150-170°C immediately prior to deposition of the solder.

The second of the three methods according to the present invention is represented in FIG. 1 by the dashed arrows. The sequence of the first two steps 100/200 --i.e., providing the component and substrate, followed by placing the component on the substrate-are the same as in the first method discussed above. However, the third and fourth steps are reversed as compared to the first method, with the final step differing somewhat from the corresponding step in the first method. The third step 400 comprises dispensing a predetermined amount of bonding compound onto at least one selected mounting pad, followed by the fourth step 300 of selectively heating each selected mounting pad to a predetermined temperature. In the present method, the mounting pads are not preheated prior to the bonding material being deposited thereon; thus, unlike the first method, the present method does not contemplate the bonding material being molten solder, molten brazing compound, or hot adhesive. Rather, the bonding compound in this method comprises a solder paste, a brazing compound paste, or an electrically conductive adhesive, with a heat-curable adhesive being preferred. Also, although IR, UV, or inert gas stream heating sources could be used to effect the heating step 300, the preferred means is a laser, with a diode laser operating the frequency range of 900-950 nm being preferred.

The third of these three methods is represented in FIG. 1 by the dotted arrows. Once again, the same four process steps are involved as in the first method, but the order is changed. The sequence of steps here comprises a first step 100 of providing the component and substrate, a second step 400 of dispensing a predetermined amount of bonding compound onto at least one selected mounting pad, a third step 200 of placing the component on the substrate such that each termination rests atop its respective mounting pad, and a fourth step 300 of selectively heating each selected mounting pad to a predetermined temperature. This method is similar to the previous method, with the middle two steps (i.e., placing and dispensing) being reversed.

In both the second and third methods, the predetermined temperature to which each mounting pad is elevated is such that each mounting pad has sufficient heat to cure or melt the bonding compound thereon so that a satisfactory joint is formed. Also, unlike the first method, in the present two methods there is not the concern of a steep thermal gradient between the bonding compound temperature and the mounting pad temperature.

It should be noted that whereas the first method involves "preheating" at least one selected mounting pad, the second and third methods involve "heating" at least one selected mounting pad. Although all three methods involve "heating", as indicated by step 300 in FIG. 1, this step is referred to as "preheating" in the first method simply because it occurs prior to the dispensing step 400.

An apparatus for carrying out the three methods disclosed above is schematically represented in FIG. 2, which shows the elements which comprise this apparatus.

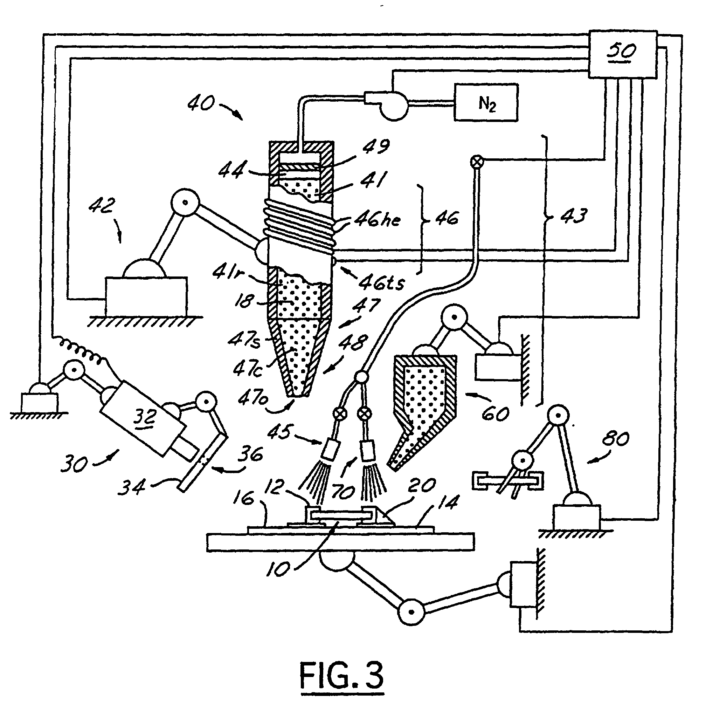

The apparatus includes means 30 for selectively heating at least one selected mounting pad, means 40 for dispensing a predetermined amount of bonding compound onto each selected mounting pad, and means 50 for controlling the sequence, timing, and operation of the heating means 30 and dispensing means 40. The apparatus may also include means 80 for placing the electronic component on the substrate such that each termination rests atop its respective mounting pad, and/or means 60 for applying a predetermined amount of surface preparation compound to each selected mounting pad or each termination, and/or means 70 for cooling each selected mounting pad and its respective predetermined amount of bonding compound. One specific embodiment containing some of these elements is shown in FIG. 3.

The heating means 30 directs heat toward each selected mounting pad and heats the substrate only immediately adjacent each selected mounting pad. As mentioned earlier, the preferred means 30 is a non-contact heating means 32, such as an IR or UV source, with a laser being the more preferred means. Masking means 34 may optionally be used in conjunction with one of these non-contact means 32. Means 34 may comprise a stencil having apertures 36 therein, through which IR, UV, or laser energy may pass onto only the selected mounting pads. As discussed above, the most preferred heating means 30 comprises one or more diode lasers operating in a frequency range of 900-950 nm. When the heating means 30 comprises a laser, means (not shown) for focusing and conveying the energy from the laser to the selected mounting pads may be used. This means may include optical elements such as mirrors, lenses, fibre optic light pipes, conditioners, etc.

The dispensing means 40 may comprise an apparatus substantially similar to that disclosed by Baker et al. As illustrated in FIG. 3, the means 40 comprises: a barrel 41 having a reservoir 41r therein for sealably containing the bonding compound 18; means 43 for controllably dispensing the bonding compound from the reservoir 41r; means 44 for preventing premature oxidation of the bonding compound contained within the reservoir 41r; means 45 for preventing premature oxidation of the bonding compound depositions; and means 42 for arranging the dispensing means 40 and mounting pads 16 such that the bonding compound may be deposited at the selected mounting pads. (As used herein, "premature oxidation" occurs if the bonding compound becomes exposed to the atmosphere or some other oxidising agent at any point after being loaded into the reservoir 41r and before the bonding compound joint 20 has cooled/cured to form a satisfactory joint.) If a hot bonding compound is to be used (as in the first method), the apparatus may also include means 46 for heating the bonding compound to a predetermined temperature and for maintaining the temperature thereat.

The means 43 for controllably dispensing the bonding compound generally comprises at least three elements: (1) conduit means 47, which may include a spout 47s connected at one end to the barrel 41, with the spout having a channel 47c therein in fluid communication with the reservoir 41r and having at least one orifice 47o at another end, such that bonding compound may flow from the reservoir through the channel and out each orifice; (2) means 48 for maintaining the bonding compound within the reservoir and channel between depositions; and (3) means 49 for urging the bonding compound through each orifice in controlled amounts during each deposition. The maintaining of means 48 may be accomplished (as illustrated in FIG. 3) by sizing each channel 47c and/or each orifice 47o such that the bonding compound is held in by capillary and surface tension forces between the depositions (in which case a meniscus of compound will be exposed at each orifice 47o), or by providing one or more shut-off valves or shutter mechanisms integral with the channel or integral with/attached to the each orifice. The urging of means 49 may be accomplished by providing a plunger/rod arrangement or a diaphragm sealably and movably held within the barrel which may physically contact the top surface of the compound or may be spaced away from the top surface of the compound with a gas pocket therebetween. When the plunger or diaphragm is urged downward, or when a pressure pulse of gas is injected into the gas pocket above the top surface of the compound, the compound will be urged through the reservoir and channel and out the orifice(s). (The timing and actuation of the various components of means 43 may be controlled by electrical, pneumatic, or other means which may be under the control of the controlling means 50, discussed in further detail below.)

Means 44 for preventing premature oxidation of the bonding compound within the reservoir 41r may include a pocket of inert gas provided within the reservoir above the top surface of the bonding compound, and/or a plunger or diaphragm sealably and movably disposed within the reservoir in contact with substantially the entire top surface of the compound. This means 44 is similar in structure and in function to the urging means 49 discussed above, and may thus be integrated therewith. Means 45 for preventing premature oxidation of the bonding compound depositions/joints may include an inert gas jet or shroud directed upon or enshrouding the depositions/joints (and/or any meniscus of compound exposed at each orifice), or an enclosure about the entire apparatus and means for keeping the enclosure filled with an inert gas. The means 42 for arranging the dispenser means 40 and mounting pads 16 may include means for moving the dispenser 40 and/or substrate 14. For example, the dispenser 40 may be carried on the end effector of a robotic mechanism (as discussed in further detail below), or the substrate may be carried on a positionable worktable which presents the substrate's selected mounting pads underneath the dispenser orifice(s). Means 46 for heating and maintaining the temperature of the bonding compound may comprise: an electric heating element 46he within the reservoir, or within or about the barrel; a fluid jacket within or about the barrel through which hot fluid is circulated; or other similar means. Means 46 may also comprise one or more temperature sensors 46ts for detecting the barrel and/or bonding compound temperature, and feedback means responsive to the temperature sensors for controlling the level of current going to the electric heating element or the flow rate and temperature of the fluid circulating through the fluid jacket.

The controlling means 50 controls the sequence, timing, and operation of the heating and dispensing means 30/40 (and, optionally, of any included means for placing, applying, or cooling 80/60/70). Controlling the sequence, timing, and operation of the steps carried out by these various means is important so that the steps for whichever method is selected are carried out in their proper order (e.g., dispensing before placing for the second method), and at the right time interval (e.g., dispensing immediately after preheating in the first method). The controlling means 50 may comprise microprocessors, input/out elements, and/or sensor elements, and may additionally carry out such actions as sending/receiving commands and/or data to or from a user or some other external apparatus. An external apparatus may be a component/PCB retrieving and positioning means, inspection means, data recording means, and so forth. The controlling means 50 may also comprise robotic elements, including at least one robotic end effector. These end effectors may in turn carry one or more of the subsystems shown in FIG. 3 so as to control the movement thereof.

The means 80 for placing the components on the substrate may include robotic and/or other automated equipment for placing the component terminations in registration with their respective substrate mounting pads. Many such "pick-and-place" systems are available and are well known to those skilled in the art to which the present invention pertains.

The means 60 for applying surface preparation compound may include a container defining a reservoir therein, means for heating and maintaining the temperature of the surface preparation compound, inerting means for preventing oxygen, moisture, or other media from coming into contact with the compound prior to application, means for controllably dispensing the compound as needed, and so forth.

The means 70 for cooling the mounting pads and the bonding compound depositions may include means for directing air, nitrogen, or some other inert media at the mounting pads/depositions, in order to assist in the formation of satisfactory bonding compound joints.

## Claims

1. A method of attaching an electronic component (10) having at least one termination (12) to a substrate (14) having at least one mounting pad (16), the attachment being between the termination (12) and a selected mounting pad (16),
the method comprising;
placing the component (10) on the substrate (14) so that the termination (12) is over the selected mounting pad (16),
dispensing a predetermined amount of bonding material over the selected mounting pad (16) either before or after the placement of the component (10) on the substrate (14),
selectively heating the selected mounting pad (16) to a predetermined temperature by focussing heat to the selected mounting pad (16), either before or after the dispensing of the bonding material, and
controlling the sequence, timing and operation of the steps of the method so that the bonding material is heated to form the said attachment without recourse to a reflow oven.

2. A method as claimed in claim 1 wherein said substrate (14) has an average temperature which remains between ambient and the lower of the melting point, a thermal degradation point, and a heat distortion point of the substrate material.

3. A method as claimed in claim 1 or 2, wherein the selective heating is carried out by non-contact heating means.

4. A method as claimed in claim 3, wherein the selective heating is carried out by heating means (30) in the form of one of the group consisting of an infrared heating source, an ultraviolet heating source, a stream of heated inert gas, and a laser.

5. A method as claimed in any one of the preceding claims further comprising masking the substrate such that the selected mounting pad is exposed to heating through the mask.

6. A method as claimed in claim 4 or 5, wherein the heating is carried out by means of a diode laser (30).

7. A method as claimed in claim 6 wherein the laser (30) is operated in a frequency range of between 900 nm and 950 nm.

## Patentansprüche

1. Verfahren zur Befestigung einer elektronischen Komponente (10) mit wenigstens einem Anschlußpol (12) auf einem Substrat (14) mit wenigstens einem Anschlußplättchen (16), wobei die Befestigung zwischen dem Anschlußpol (12) und einem ausgewählten Anschlußplättchen (16) erfolgt,
welches Verfahren folgendes beinhaltet:
Plazieren der Komponente (10) auf dem Substrat (14) derart, daß der Anschlußpol (12) über dem gewählten Anschlußplättchen (16) liegt,
Ausgeben einer vorgegebenen Menge Bondierstoff auf das gewählte Anschlußplättchen (16) entweder vor oder nach dem Plazieren der Komponente (10) auf dem Substrat (14),
selektives Erwärmen des gewählten Anschlußplättchens (16) auf eine vorgegebene Temperatur durch Fokussieren von Wärme auf das gewählte Anschlußplättchen (16) entweder vor oder nach der Ausgabe von Bondierstoff, und
Steuern der Abfolge, Synchronisierung und Ausführung der Schritte des Verfahrens derart, daß der Bondierstoff erwärmt wird, so daß die besagte Befestigung ohne Rückgriff auf einen Aufschmelzofen hergestellt wird.

2. Verfahren nach Anspruch 1, worin besagtes Substrat (14) eine mittlere Temperatur hat, die zwischen der Umgebungstemperatur und der niedrigeren Temperatur zwischen einem Schmelzpunkt, einer thermischen Schadtemperatur und einer Wärmeverzugstemperatur des Substratwerkstoffes bleibt.

3. Verfahren nach Anspruch 1 oder 2, worin die selektive Erwärmung durch kontaktfreie Heizmittel bewerkstelligt wird.

4. Verfahren nach Anspruch 3, worin die selektive Erwärmung durch Heizmittel (30) in Form eines Mittels aus einer Gruppe bewerkstelligt wird, die aus einer Infrarotwärmequelle, einer Ultraviolettwärmequelle, einem heißen Inertgasstrom und einem Laser besteht.

5. Verfahren nach einem beliebigen der vorangehenden Ansprüche, außerdem die Abdeckung des Substrates mit einer Maske beinhaltend, so daß das ausgewählte Anschlußplättchen der Wärme durch die Maske hindurch ausgesetzt ist.

6. Verfahren nach Anspruch 4 oder 5, worin die Heizung mittels eines Diodenlasers (30) durchgeführt wird.

7. Verfahren nach Anspruch 6, worin der Laser (30) in einem Frequenzbereich zwischen 900 nm und 950 nm betrieben wird.

## Revendications

1. Procédé de fixation d'un composant électronique (10) comportant au moins une terminaison (12) sur un substrat (14) comportant au moins une pastille de montage (16), la fixation se situant entre la terminaison (12) et la pastille de montage sélectionnée (16),
le procédé comprenant,
le positionnement du composant (10) sur le substrat (14) de sorte que la terminaison (12) soit sur la pastille de montage sélectionnée (16),
la distribution d'une quantité prédéterminée de matériau de connexion sur la pastille de montage sélectionnée (16) soit avant, soit après le positionnement du composant (10) sur le substrat (14),
le chauffage sélectif de la pastille de montage sélectionnée (16) à une température prédéterminée en focalisant la chaleur vers la pastille de montage sélectionnée (16), soit avant, soit après la distribution du matériau de connexion, et
la commande de la séquence, de la synchronisation et de la mise en oeuvre des étapes du procédé de sorte que le matériau de connexion soit chauffé pour former ladite fixation sans avoir recours à un four de refusion.

2. Procédé selon la revendication 1, dans lequel ledit substrat (14) présente une température moyenne qui reste entre la température ambiante et le point le plus bas parmi le point de fusion, un point de dégradation thermique et un point de distorsion thermique du matériau de substrat.

3. Procédé selon la revendication 1 ou 2, dans lequel le chauffage sélectif est exécuté par un moyen de chauffage sans contact.

4. Procédé selon la revendication 3, dans lequel le chauffage sélectif est exécuté par un moyen de chauffage (30) sous la forme d'un élément du groupe constitué d'une source de chauffage par infrarouge, d'une source de chauffage par ultraviolets, d'un flux de gaz inerte chauffé, et d'un laser.

5. Procédé selon l'une quelconque des revendications précédentes, comprenant en outre le masquage du substrat de sorte que la pastille de montage sélectionnée soit exposée au chauffage à travers le masque.

6. Procédé selon la revendication 4 ou 5, dans lequel le chauffage est exécuté au moyen d'un laser à diode (30).

7. Procédé selon la revendication 6, dans lequel le laser (30) est mis en oeuvre dans une plage de fréquences se trouvant entre 900 nm et 950 nm.
